# EUROPÄISCHE PATENTSCHRIFT

(11) **EP 2 165 412 B1**
(45) Veröffentlichungstag und Bekanntmachung des Hinweises auf die Patenterteilung: **18.09.2013**
(21) Anmeldenummer: 08758185.6
(22) Anmeldetag: 17.06.2008
(51) Int. Cl.: H02P 7/28, G01R 35/04, G05B 19/21, H03F 3/45, G11C 7/08

(54) **VORRICHTUNG ZUR SENSORLOSEN POSITIONIERUNG MIT SIGNALVERSTÄRKER**
APPARATUS FOR SENSORLESS POSITIONING WITH SIGNAL AMPLIFIER
DISPOSITIF POUR LE POSITIONNEMENT SANS CAPTEUR AVEC UN AMPLIFICATEUR DE SIGNAUX

(30) Priorität: 27.06.2007 DE 102007030150; 27.06.2007 DE 102007030149; 19.04.2008 DE 102008019821
(43) Veröffentlichungstag der Anmeldung: 24.03.2010
(73) Patentinhaber: Conti Temic Microelectronic GmbH, 90411 Nürnberg (DE)
(72) Erfinder: SCHULTER, Wolfgang, Dr., 88709 Meersburg (DE); RAU, Stefan, 88085 Langenargen (DE); WEBER, Helmut, 85053 Ingolstadt (DE); GRÜNDER, Thomas, 88677 Markdorf (DE); SENSCHE, Carsten, 86609 Donauwörth (DE)
(86) Internationale Anmeldenummer: PCT/DE2008/000983
(87) Internationale Veröffentlichungsnummer: WO 2009/000234

(56) Entgegenhaltungen:
- EP-A- 0 349 328
- EP-A- 1 659 683
- DE-A1- 10 124 615
- US-A1- 2004 222 844
- US-B1- 6 577 480

## Beschreibung

Die vorliegende Erfindung betrifft eine Vorrichtung bzw. ein Verfahren zur sensorlosen Positionsermittlung nach dem Oberbegriff der unabhängigen Patentansprüche.

Zur Positionierung von z. B. Sitzen oder Fensterhebern in Kraftfahrzeugen werden häufig Hallsensoren zur relativen Positionserfassung eingesetzt. Diese sind bei einer sensorlosen Positionserfassung (nachfolgend SLP genannt) nicht mehr notwendig.

Die Druckschrift WO 2006/111144 beschreibt ein Verfahren zur sensorlosen Ermittlung der Position eines Rotors eines mechanisch kommutierten Gleichstrommotors bzw. ein Verfahren zur sensorlosen Ermittlung der Drehzahl bzw. des Drehwinkels eines mechanisch kommutierten Gleichstrommotors.

Dabei wird anhand der Kommutierungswelligkeit (Ripple, Schwankungen) des Elektromotors, welche bspw. durch die Änderung der Ankerinduktivität oder des Ankerwiderstandes bei der Kommutierung des Elektromotors verursacht ist, die Position des Rotors des mechanisch kommutierten Elektromotors bzw. des Drehwinkels und der Drehzahl dieses Elektromotors ermittelt. Dazu werden die durch die Kommutierung verursachten Strom- oder Spannungsschwankungen erfasst und weiterbearbeitet.

Hierzu müssen die durch die Kommutierung verursachten Strom- bzw. Spannungsschwankungen mit kleinen Amplituden von den anderen Strom-/Spannungsschwankungen mit großen Amplituden, die bspw. durch die Schwankungen in der Bordnetzspannung oder bei der Anlauf- oder Bremsphase oder beim mechanischen Endanschlag des Elektromotors auftreten können, möglichst in Echtzeit, d. h. mit möglichst kurzer Zeitverzögerung, gefiltert und zur weiteren Bearbeitung bspw. zur Analog-DigitalWandlung weitergeleitet werden.

Dabei weisen sowohl die durch die Kommutierung verursachten Stromschwankungen als auch die anderen Stromschwankungen, die bspw. durch die Schwankungen in der Bordnetzspannung oder bei der Anlauf- oder Bremsphase oder beim mechanischen Endanschlag des Elektromotors auftreten können, sehr breite und sich teilweise überlappende Frequenzbereiche auf. Zudem ändern sich die Frequenzbereiche der Schwankungen in Abhängigkeit vom Betriebszustand des Elektromotors ständig.

Ein Frequenzfilter, bspw. ein Bandpassfilter, ist aufgrund des beschränkten Frequenzbereichs (Durchlassbereichs) des Filters nicht angeeignet, die durch die Kommutierung verursachten Stromschwankungen von den anderen, in der Regel einen großen Werteintervall aufweisenden Stromschwankungen zu trennen.

Das Dokument DE10124615 kommt daher ohne Filter aus und beschreibt ein Verfahren zum Korrigieren einer Drehstellungsbestimmung einer Antriebswelle eines kommutierten Gleichstrommotors durch Auswerten der im Ankerstromsignal enthaltenen Stromrippel bei Auftreten von Fehlrippeln, wenn innerhalb eines einen definierten Zeitpunkt nach dem zuletzt detektierten Stromrippel umgebenden Toleranzbereiches kein weiterer Stromrippel erkannt wird, wobei die Größe des den Zeitpunkt einer erwarteten Stromrippeldetektion umgebenden Toleranzbereiches, in dem ein Korrektur des Zählergebnisses nicht erforderlich ist, dynamisch an sich ändernde Betriebszustände des Gleichstrommotors angepasst wird.

Der vorliegenden Erfindung liegt daher die Aufgabe zugrunde, eine Vorrichtung bzw. ein Verfahren der eingangs genannten Art vorzustellen, die bzw. das eine Trennung der durch die Kommutierung verursachten Strom-/Spannungsschwankungen mit relativ kleinen Amplituden von den anderen Strom-/Spannungsschwankungen mit relativ großen Amplituden infolge der Schwankungen in der Bordnetzspannung bzw. bei der Anlauf- oder Bremsphase oder beim mechanischen Endanschlag des Elektromotors mit kurzer Zeitverzögerung und über den gesamten Messbereich des Motorstroms oder der Motorspannung ermöglicht.

Diese Aufgabe wird mit einer Vorrichtung mit den Merkmalen des unabhängigen Anspruchs 1 bzw. mit einem Verfahren mit den Merkmalen des unabhängigen Anspruchs 11 gelöst. Vorteilhafte Ausgestaltungen der Erfindung ergeben sich aus den Unteransprüchen und der Beschreibung.

Kerngedanke der Erfindung ist, die durch die Kommutierung verursachten Schwankungen des Ankerstroms bzw. der Ankerspannung von den Schwankungen des Motorstroms oder der Motorspannung mithilfe einer Verstärkereinheit in Abhängigkeit eines steuerbaren bzw. veränderbaren Verschiebewertes (Offset) zu trennen, wobei dieser Verschiebewert entsprechend dem/der Motor-strom/spannung bzw. den Schwankungen des/der Motorstrom/spannung verändert.

Durch den veränderbaren Verschiebewert kann auch der Offsetbereich der Verstärkereinheit den Schwankungen des/der Motor-strom/spannung angepasst werden. Damit kann eine hohe Verstärkung über den gesamten Messbereich für den Ankerripplestrom bzw. die Ankerripplespannung vom Rotor ermöglicht werden.

Da die Strom-/Spannungsschwankungen infolge der Schwankungen in der Bordnetzspannung bzw. bei der Anlauf- oder Bremsphase oder beim mechanischen Endanschlag des Elektromotors sehr groß sind, muss der Verschiebewert entsprechend dieser Stromschwankungen auch in einem großen Wertebereich geändert werden. Dazu muss der Verschiebewert mit möglichst kurzer Zeitverzögerung diesen Stromschwankungen angepasst werden.

So wird der Verschiebewert, nämlich das Offset, erfindungsgemäß in Abhängigkeit eines Steuersignals geändert, wobei dieses Steuersignal von den vorangehenden Motorstrom- bzw. Motorspannungswerten abgeleitet wird.

In einer ersten Ausführungsform wird das Steuersignal mithilfe von stochastischen Schätzverfahren, insbesondere mithilfe von einem Kalmanfilter, aus den vorangehenden Motorstrom- bzw. Motorspannungswerten iterativ abgeleitet.

In einer weiteren Ausführungsform wird das Steuersignal aus ein oder mehreren aktuell gemessenen Messwerten der Schwankungen des Motorstroms bzw. der Motorspannung ableitet.

Aus dem Steuersignal wird dann der Verschiebewert ermittelt. In einer ersten Ausführungsform wird eine Mehrzahl von digitalen Zwischensignalen mithilfe von einem Mikrokontroller oder Mikroprozessor aus dem Steuersignal erzeugt. Diese digitalen Zwischensignale werden dann von einem nachgeschalteten R2R-Netzwerk in ein analoges Offsetsignal, nämlich einen Verschiebewert, umgewandelt. Durch Setzen eines oder mehrerer digitalen Zwischensignals von Null auf Eins entsprechend dem Wert des Steuersignals kann der Wert des Verschiebewerts entsprechend den Schwankungen des Motorstroms bzw. der Motorspannung geändert werden. Dies hat den Vorteil, dass aufgrund der Schnelligkeit des R2R-Netzwerks das Bereitstellen des Verschiebewertes ohne eine störende Zeitverzögerung erfolgt werden kann. Zudem Dank der Eigenschaft des R2R-Netzwerks kann der Offsetbereich mit einer beliebigen Auflösung und ohne Geschwindigkeitsverlust allein durch Hinzufügen weiterer R2R-Widerstandsgruppe erweiterbar.

In einer weiteren Ausführungsform wird aus dem Steuersignal ein pulsweitenmoduliertes Zwischensignal erzeugt. Das Zwischensignal wird dann von einem nachgeschalteten Tiefpass in ein Offsetsignal, nämlich einen Verschiebewert, umgewandelt. Durch Änderung der Tastverhältnis (Duty Cycle) des pulsweitenmodulierten Zwischensignals entsprechend dem Wert des Steuersignals kann der Wert des Verschiebewerts entsprechend den Schwankungen (SM) des Motorstroms bzw. der Motorspannung geändert werden.

Im Folgenden wird die erfindungsgemäße Vorrichtung anhand der Ausführungsbeispiele unter Zuhilfenahme von Figuren näher erläutert. In den Figuren werden nur die Komponenten dargestellt, die für die Beschreibung dieser Erfindung unerlässlich sind. Es zeigen,
- Fig. 1:: Blockschaltbild der erfindungsgemäßen Vorrichtung,
- Fig. 2:: Blockschaltbild eines ersten Ausführungsbeispiels der erfindungsgemäßen Vorrichtung,
- Fig. 3:: Blockschaltbild eines zweiten Ausführungsbeispiels der erfindungsgemäßen Vorrichtung,
- Fig. 4:: graphische Darstellung eines zeitlichen Verlaufes des Motorstroms (Figur 4.A) und der durch die Kommutierung des Motor verursachten Ankerstromschwankungen SA (Figur 4.B) sowie der durch die Schwankungen bei der Anlaufphase des Elektromotors verursachten Motorstromschwankungen SM (Figur 4.C),
- Fig. 5:: graphische Darstellung eines zeitlichen Verlaufes des Motorstroms bzw. der Motorspannung (Figur 4.A) und des Verschiebewertes (Figur 4.B) sowie des Ausgangssignals der erfindungsgemäßen Vorrichtung (Figur 4.C),
- Fig. 6:: Schaltungsbild des ersten Ausführungsbeispiels der erfindungsgemäßen Vorrichtung, und
- Fig. 7:: Schaltungsbild des zweiten Ausführungsbeispiels der erfindungsgemäßen Vorrichtung.

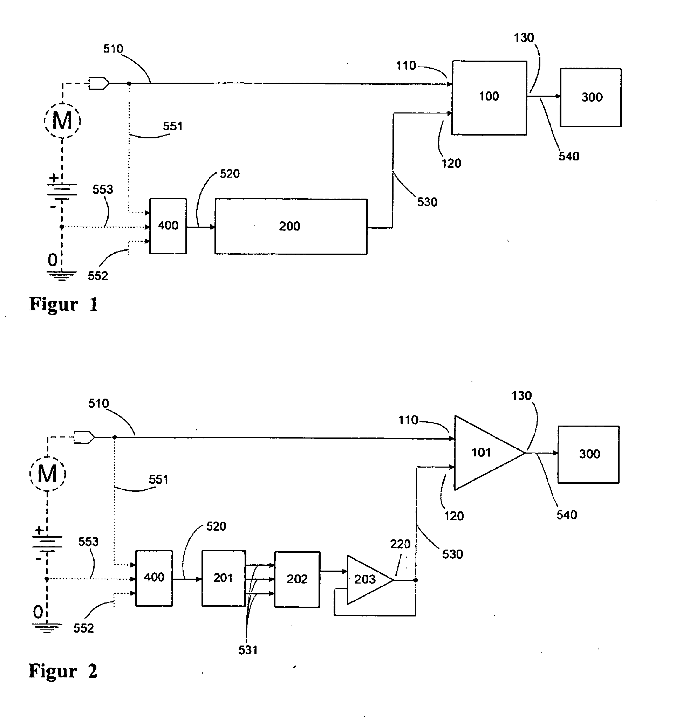

Die Figur 1 zeigt ein Blockschaltbild der erfindungsgemäßen Vorrichtung. Demnach weist die Vorrichtung eine Verstärkereinheit 100 und eine Einheit 200 zur Erzeugung von einem steuerbaren Verschiebewert 530 auf. Die Verstärkereinheit 100 weist wiederum einen Messsignaleingang 110 für das Messsignal 510, nämlich die Motorspannung bzw. den Motorstrom aus dem Rotor des Elektromotors M, und einen Offseteingang 120 für den Verschiebewert 530, nämlich das Offset bzw. die Offsetspannung, sowie einen Ausgang 130 für das verstärkte Ausgangssignal 540, bspw. für einen nachgeschalteten Analog-Digital-Wandler 300, auf.

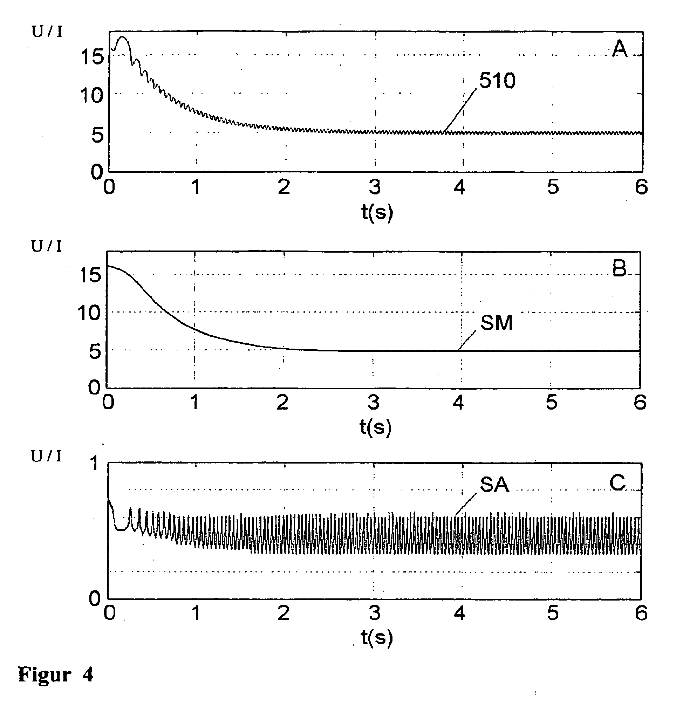

Das Messsignal 510 enthält neben den durch die Kommutierung des Motors M verursachten Strom-/Spannungsschwankungen SA mit vergleichsweise kleinen Amplituden noch die durch die Schwankungen in der Bordnetzspannung bzw. bei der Anlauf- oder Bremsphase oder beim mechanischen Endanschlag des Elektromotors verursachten Schwankungen SM mit vergleichsweise großen Amplituden, wie es die Figur 4.A veranschaulicht.

Der Verschiebewert 530 wird von der Einheit 200 in Abhängigkeit eines Steuersignals 520 erzeugt. Das Steuersignal 520 wird in einer ersten Ausführungsform vorzugsweise mithilfe eines Kalmanfilters in der Einheit 400 aus den vorangehenden Motorstrom- bzw. Motorspannungswerten 551 iterativ abgeleitet. Alternativ kann das Steuersignal 520 aus ein oder mehreren aktuell gemessenen Messwerten 551 bestimmt werden.

Alternativ kann das Steuersignal 520 aus unmittelbar nach dem Zusammenbau der Vorrichtung mit dem Elektromotor M bei verschiedenen Betriebszuständen des Elektromotors M gemessen und abspeicherten Messwerten 552 für die Schwankungen SM des Motorstroms bzw. der Motorspannung ableitet werden. Zum Messen der Werten 552 wird der Elektromotor M bei verschiedenen Betriebszuständen und unter verschiedenen, beim späteren Betrieb vorkommenden Betriebsspannungen bzw. Betriebsströmen gefahren. Dabei misst ein hier nicht näher dargestelltes Messgerät die Schwankungen SM des Motorstroms bzw. der Motorspannung bzw. die Betriebsspannung bzw. den Betriebsstrom am Elektromotor M und speichert die gemessenen Werten 552 mit den entsprechenden Betriebsspannungs-/stromwerten und den jeweiligen Betriebszuständen des Elektromotors M zugeordnet in einer hier ebenfalls nicht näher dargestellten Speichereinheit der erfindungsgemäßen Vorrichtung ab.

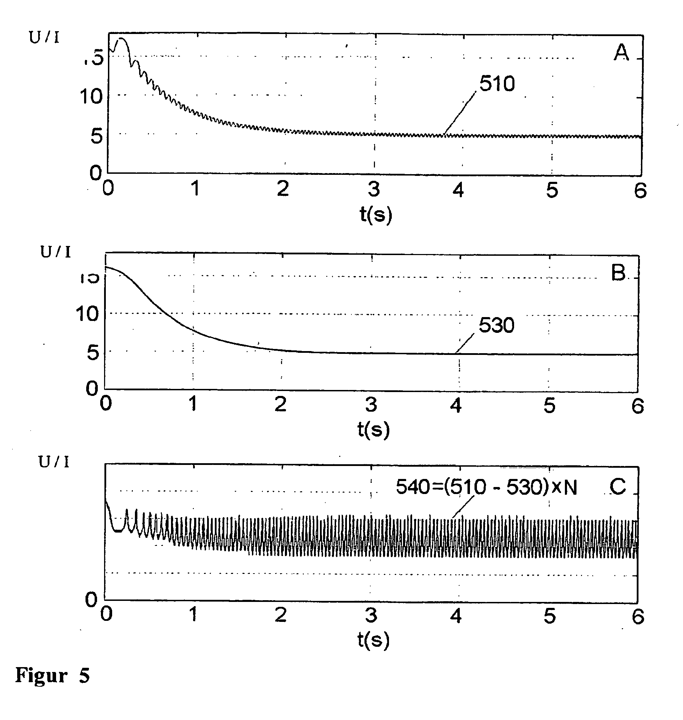

Die Verstärkereinheit 100 soll die Schwankungen SA von den Schwankungen SM trennen und diese SA dann verstärken. Dabei subtrahiert die Verstärkereinheit 100 den Verschiebewert 530 von dem Messwert 510. Entspricht der Verschiebewert 530 der aktuellen Amplitude der Schwankungen SM, so bleibt nach dem Subtrahieren nur noch die aktuelle Amplitude der Schwankungen SA, die der aktuellen Ankerstromripple bzw. Ankerspannungsripple entspricht, wie es die Figur 5 veranschaulicht. Diese Schwankungen SA werden dann von der Verstärkereinheit 100 verstärkt und an die nachgeschaltete Einheit 300, bspw. Analog-Digital-Wandler, zur Weiterbearbeitung weitergeleitet. Vorzugsweise ist die Verstärkereinheit 100 ein Operationsverstärker 101.

Die Figur 2 zeigt ein erstes Ausführungsbeispiel der erfindungsgemäßen Vorrichtung. Demnach weist die Einheit 200 eine Recheneinheit 201, bspw. einen Mikrokontroller oder Mikroprozessor, und ein R2R-Netzwerk 202 sowie einen Spannungsfolger 203, einen rückgekoppelten Operationsverstärker, auf. Die Recheneinheit 201 berechnet anhand des Steuersignals 520 eine Mehrzahl, bspw. drei, von digitalen Ausgangssignalen 531. Diese digitalen Ausgangssignale 531 werden vom R2R-Netzwerk 202 in einen analogen Verschiebewert 530, nämlich Offset, umgewandelt. Aus drei digitalen Ausgangssignalen 531 lassen sich 2³=8 verschiedene Verschiebewerte 530 bestimmen und somit auch acht Offsetbereiche einstellen. Je nach Anforderungen können hier auch nur zwei, vier oder mehr als acht, bspw. sechzehn, Verschiebewerte 530 bzw. Offsetbereiche eingestellt werden. Hierzu muss lediglich eine passende Anzahl von digitalen Ausgangssignale 531 für das R2R-Netzwerk 202 mit entsprechender Anzahl von R-2R-Widerstandsgruppen eingesetzt werden.

Alternativ zu der Recheneinheit 201 und dem R2R-Netzwerk 202 kann auch ein interner Prozessor mit integriertem Digital-Analog-Wandler zur Erzeugung vom Verschiebewert 530 verwendet werden. Dabei wird der Analogausgang des Wandlers bzw. Prozessors mit dem Eingang des Spannungsfolger 203 verbunden.

Der Spannungsfolger 203 dient zur Entkopplung des R2R-Netzwerks 202 von dem Operationsverstärker 101.

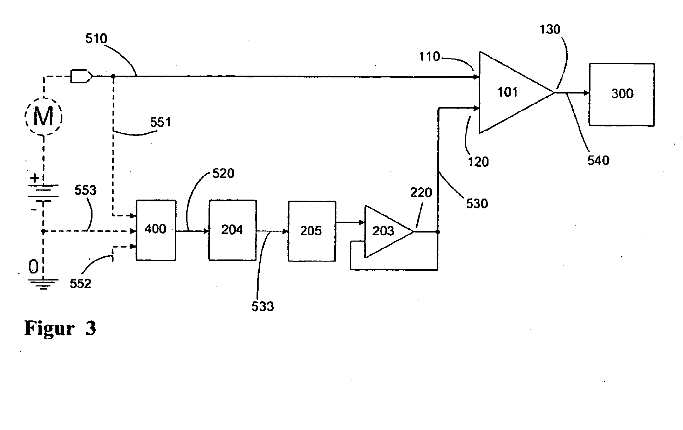

Die Figur 3 zeigt ein zweites Ausführungsbeispiel der erfindungsgemäßen Vorrichtung. Demnach weist die Einheit 200 neben dem Spannungsfolger 203 eine Pulsweitenmodulationseinheit 204 und einen Tiefpass 205 zum Bereitstellen vom Verschiebewert 530 auf. Aus dem Steuersignal 520 erzeugt die Pulsweitenmodulationseinheit 204 ein pulsweitenmoduliertes Ausgangssignal 533. Dieses PWM-Signal 533 wird dann vom nachgeschalteten Tiefpass 205 in einen analogen Verschiebewert 530 umgewandelt. Die Größe des Verschiebewertes 530 ist anhand des Tastverhältnisses (Duty Cycle) des PWM-Signals 533 und durch anschließende Tiefpassfilterung stufenlos einstellbar. Folglich ist der Offsetbereich des Operationsverstärkers 101 ebenfalls stufenlos einstellbar.

Ähnlich wie beim ersten Ausführungsbeispiel dient der Spannungsfolger 203 zur Entkopplung des Tiefpasses 205 von dem Operationsverstärker 101.

Die Figur 5 zeigt durch eine graphische Darstellung des zeitlichen Verlaufes des Motorstroms (Figur 4.A) und des Verschiebewertes (Figur 4.B) sowie des Ausgangssignals der Vorrichtung (Figur 4.C) und das Funktionsprinzip der erfindungsgemäßen Vorrichtung.

Die Verstärkereinheit 100 subtrahiert von der Motorsspannung 510 den Verschiebewert 530. Der Verschiebewert 530 ist von der Motorsspannung 510 iterativ abgeleitet und entspricht den Motorspannungsschwankungen SM. Folglich bleibt nach dem Subtrahieren nur die Ankerspannungsschwankungen SA üblich. Diese Ankerspannungsschwankungen SA werden dann mit dem Verstärkungsfaktor N der Verstärkereinheit multipliziert. Das Ergebnis wird als Ausgangssignal 540 zur Weiterbearbeitung an Analog-Digital-Wandler 300 weitergeleitet.

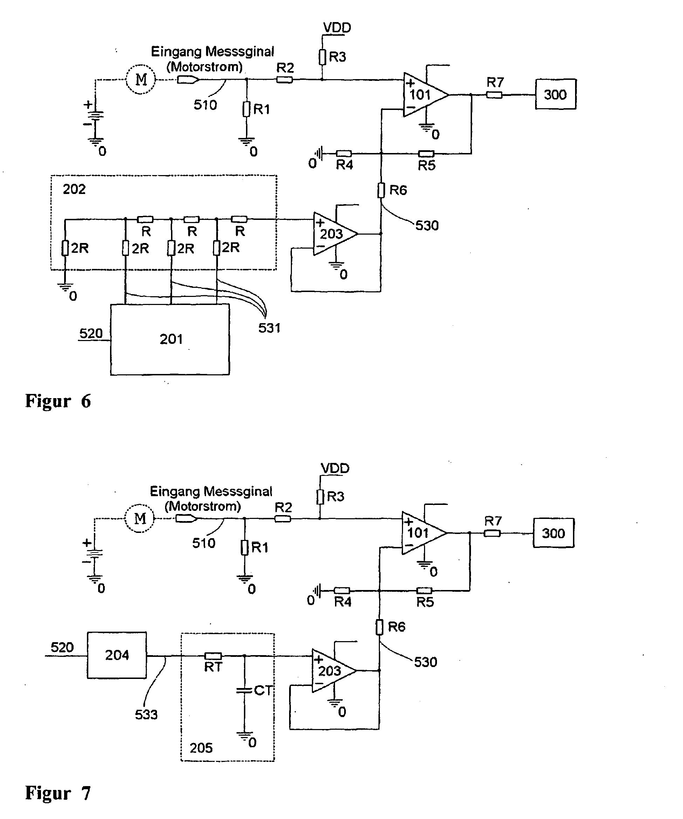

Die Figuren 6 und 7 zeigen jeweils eine schaltungstechnische Realisierung der Vorrichtung in den Figuren 2 und 3. Der Widerstand R1 in den beiden Figuren 6 und 7 ist ein Messwiderstand (Shunt) und dient zum Messen vom Motorstrom 510. Die beiden Widerständen R2 und R3 bewirken eine Eingangsspannungsanhebung (Pull Up) für den Operationsverstärker 101, damit dieser 101 auch ohne Motorstrom, d. h. Motorstrom gleich 0A, im Arbeitsbereich liegt. Die Widerstände R4, R5 und R6 dienen zur Einstellung sowie Verstärkung des Verschiebewertes 530. Der Widerstand R7 schützt den Eingang des Analog-Digital-Wandlers 300 vor Übersteuerung in einem Fehlerfall (Überlast, Kurzschluss o. ä.) des Motors. Statt des Widerstands R7 kann Zener-Diode oder Kondensator zur Spannungsstabilisierung verwendet werden. Alternativ kann eine Schutzmassnahme durch Versorgung des Operationsverstärkers 101 mit Mikrokontroller-Betriebsspannung erzielt werden.

Das R2R-Netzwerk 202 in der Figur 6 besteht aus drei R-2R-Widerstandgruppen. Mit diesem R2R-Netzwerk 202 lassen sich maximal 2³=8 verschiedene Verschiebewerte 530 erzeugen.

Der Widerstand RT und die Kapazität CT in der Figur 7 bilden ein RC-Tiefpass, welcher aus dem PWM-Signal 533, welches von der Pulsweitenmodulationseinheit 204 erzeugt wird, eine Gleichspannung, nämlich analogen Verschiebewert 530, bildet.

Anstatt des Operationsverstärkers 203 als Spannungsfolger kann hier auch ein als Emitterfolger beschalteter Transistor verwendet werden.

Durch die erfindungsgemäßen Schaltungsanordnungen ist ein Strommessverstärker mit einer relativ hohen Verstärkung bei einer gleichzeitig großen Verstärkungsdynamik realisiert.

Mithilfe dieser erfindungsgemäßen Vorrichtung ist eine hohe Kleinsignalverstärkung über den gesamten Strommessbereich ohne eine aufwendige Verstärkungsumschaltung möglich. Dabei kann die Signalerzeugungseinheit für das Offsetsignal in jeder bereits bestehenden Signalverstärkerschaltung integriert werden. Durch die Anwendung dieser Vorrichtung sind keine Hardware-Änderungen zur Anpassung neuer Motortypen notwendig.

Der erfindungsgemäße Vorrichtung zeichnet sich insbesondere dadurch aus, dass die von der Kommutierung verursachten Stromschwankungen mit kleiner Amplitude bei gleichzeitig großen Motorströmen, wie sie z. B. beim mechanischen Endanschlag auftreten können, besser erfasst und von einem Analog-Digital-Wandler mit einem geringeren Quantisierungsfehler in ein digitales Signal umgewandelt werden können.

### Bezugszeichenliste

- 100: Verstärkereinheit
- 101: Operationsverstärker
- 110: Messsignaleingang
- 120: Offseteingang
- 130: Ausgang der Verstärkereinheit 100
- 200: Einheit zur Erzeugung von steuerbarem Verschiebewert
- 201: Recheneinheit, bspw. Mikrokontroller oder Mikroprozessor
- 202: R2R-Netzwerk
- 203: Spannungsfolger
- 204: Pulsweitenmodulationseinheit
- 205: Tiefpass
- 300: Analog-Digital-Wandler bzw. Analog-Digital-Wandler und Signalauswerteeinheit
- 400: Einheit zur Vorbereitung von Zwischensignal für das Steuersignal
- 510: Messsignal, Messstrom bzw. Messspannung
- 520: Steuersignal
- 530: Verschiebewert (Offset)
- 540: Ausgangssignal der Verstärkereinheit
- 531: Eine Mehrzahl von digitalen Signalen
- 533: Pulsweitenmoduliertes Zwischensignal
- 551: Vorangehende Motorstrom-/spannungswerte
- 552: Im Vorfeld gemessen und abgespeicherte Messwerte für die Schwankungen mit großen Amplituden, die bspw. durch die Schwankungen in der Bordnetzspannung oder bei der Anlauf- oder Bremsphase oder beim mechanischen Endanschlag des Elektromotors auftreten können
- 553: Bezugspotential
- M: Elektromotor
- R, 2R: Widerstandgruppe vom R2R-Netzwerk 202
- R1, R2, ..., R7: Widerstände
- RT, CT: Widerstand und Kapazität des Tiefpasses 205
- SA: Durch die Kommutierung verursachter Strom- bzw. Spannungsschwankungen mit kleinen Amplituden
- SM: Strom-/Spannungsschwankungen mit großen Amplituden, die bspw. durch die Schwankungen in der Bordnetzspannung oder bei der Anlauf- oder Bremsphase oder beim mechanischen Endanschlag des Elektromotors auftreten können

## Patentansprüche

1. Vorrichtung zur Ermittlung der aktuellen Position eines Rotors, insbesondere des Drehwinkels des Rotors, eines Elektromotors (M),
- wobei diese Vorrichtung die aktuelle Position des Rotors anhand der durch die Kommutierung des Elektromotors verursachten Schwankungen (SA) des Ankerstroms bzw. der Ankerspannung des Elektromotors (M) ermittelt, **dadurch gekennzeichnet, dass**
- diese Vorrichtung die Schwankungen (SA) des Ankerstroms bzw. der Ankerspannung von den Schwankungen (SM) des Motorstroms bzw. der Motorspannung mithilfe einer Verstärkereinheit (100) in Abhängigkeit eines steuerbaren Verschiebewertes (530) trennt,
- wobei die Vorrichtung diesen Verschiebewert (530) entsprechend dem Motorstrom oder der Motorspannung bzw. den Schwankungen (SM) des Motorstroms oder der Motorspannung verändert.

2. Vorrichtung nach Anspruch 1, **dadurch gekennzeichnet, dass** die Vorrichtung den Verschiebewert (530) in Abhängigkeit von einem Steuersignal (520) verändert, wobei die Vorrichtung dieses Steuersignal (520) von den vorangehenden Motorstrom- bzw. der Motorspannungswerten **ableitet.**

3. Vorrichtung nach Anspruch 2, **dadurch gekennzeichnet, dass** die Vorrichtung das Steuersignal (520) mithilfe von stochastischen Schätzverfahren aus den vorangehenden Motorstrom- bzw. Motorspannungswerten iterativ **ableitet.**

4. Vorrichtung nach Anspruch 3, **dadurch gekennzeichnet, dass** die Vorrichtung das Steuersignal (520) mithilfe von einem Kalmanfilter aus den vorangehenden Motorstrom- bzw. Motorspannungswerten iterativ **ableitet.**

5. Vorrichtung nach Anspruch 2, **dadurch gekennzeichnet, dass** die Vorrichtung das Steuersignal (520) aus ein oder mehreren aktuell gemessenen Messwerten (551) der Schwankungen (SM) des Motorstroms bzw. der Motorspannung ableitet.

6. Vorrichtung nach Anspruch 2, **dadurch gekennzeichnet, dass** die Vorrichtung das Steuersignal (520) aus unmittelbar nach dem Zusammenbau der Vorrichtung mit dem Elektromotor (M) bei verschiedenen Betriebszuständen des Elektromotors (M) gemessen und abspeicherten Messwerten (552) der Schwankungen (SM) des Motorstroms bzw. der Motorspannung ableitet.

7. Vorrichtung nach Anspruch 6, **dadurch gekennzeichnet, dass** zu den Betriebszuständen des Elektromotors (M) gehören:
- Elektromotor (M) startet,
- Elektromotor (M) beschleunigt,
- Elektromotor (M) bremst,
- Elektromotor (M) erreicht mechanischen Endanschlag.

8. Vorrichtung nach einem der Ansprüche 2 bis 7, **dadurch gekennzeichnet, dass** diese Vorrichtung aus dem Steuersignal (520) eine Mehrzahl von digitalen Signalen (531) ableitet und den Verschiebewert (530) aus dieser Mehrzahl von digitalen Signalen (531) mithilfe eines R/2R-Netzwerks (202) erzeugt.

9. Vorrichtung nach einem der Ansprüche 2 bis 7, **dadurch gekennzeichnet, dass** diese Vorrichtung aus dem Steuersignal (520) mithilfe von Pulsweitenmodulation ein pulsweitenmoduliertes Zwischensignal (533) erzeugt und aus dem Zwischensignal (533) den Verschiebewert (530) erzeugt.

10. Vorrichtung nach Anspruch 9, **dadurch gekennzeichnet, dass** diese Vorrichtung den Verschiebewert (530) aus dem pulsweitenmodulierten Zwischensignal (533) anhand eines Tiefpasses (205) erzeugt.

11. Verfahren zur Ermittlung der aktuellen Position eines Rotors, insbesondere des Drehwinkels des Rotors, eines Elektromotors (M),
- wobei die aktuelle Position des Rotors anhand der **durch die Kommutierung des Elektromotors verursachten** Schwankungen (SA) des Ankerstroms bzw. der Ankerspannung **des Elektromotors ermittelt wird,**
**dadurch gekennzeichnet, dass**
- **die Schwankungen (SA) des Ankerstroms bzw. der Ankerspannung** von den Schwankungen (SM) des Motorstroms oder der Motorspannung durch eine Verstärkereinheit (100) in Abhängigkeit eines steuerbaren Verschiebewertes (530) getrennt **werden,**
- wobei dieser Verschiebewert (530) entsprechend dem Motorstrom oder der Motorspannung bzw. den Schwankungen (SM) des Motorstroms oder der Motorspannung verändert wird.

## Claims

1. A device for determining the current position of a rotor, in particular the angle of rotation of the rotor, of an electric motor (M),
- wherein said device determines the current position of the rotor based on the variations (SA) of the armature current or the armature voltage of the electric motor (M) caused by the commutation of the electric motor,
**characterized in that**
- said device separates the variations (SA) of the armature current or the armature voltage from the variations (SM) of the motor current or the motor voltage by means of an amplifier unit (100) in accordance with a controllable displacement value (530),
- wherein the device changes said displacement value (530) in accordance with the motor current or the motor voltage or the variations (SM) of the motor current or the motor voltage.

2. The device according to claim 1, **characterized in that** the device changes the displacement value (530) in accordance with a control signal (520), wherein the device **derives** said control signal (520) from the preceding motor current or motor voltage values.

3. The device according to claim 2, **characterized in that** the device iteratively **derives** the control signal (520) from the preceding motor current or motor voltage values by means of stochastic estimation methods.

4. The device according to claim 3, **characterized in that** the device iteratively **derives** the control signal (520) from the preceding motor current or motor voltage values by means of a Kalman filter.

5. The device according to claim 2, **characterized in that** the device derives the control signal (520) from one or several currently measured values (551) of the variations (SM) of the motor current or the motor voltage.

6. The device according to claim 2, **characterized in that** the device derives the control signal (520) from measured values (552) of the variations (SM) of the motor current or the motor voltage which were measured and stored in different operating states of the electric motor (M) immediately after assembly of the device with the electric motor (M).

7. The device according to claim 6, **characterized in that** the operating states of the electric motor (M) include:
- electric motor (M) starts,
- electric motor (M) accelerates,
- electric motor (M) decelerates,
- electric motor (M) reaches mechanical limit stop.

8. The device according to any one of claims 2 to 7, **characterized in that** said device derives a plurality of digital signals (531) from the control signal (520) and generates the displacement value (530) from said plurality of digital signals (531) by means of an R/2R network (202).

9. The device according to any one of claims 2 to 7, **characterized in that** said device generates a pulse-width-modulated intermediate signal (533) from the control signal (520) by means of pulse width modulation and generates the displacement value (530) from said intermediate signal (533).

10. The device according to claim 9, **characterized in that** said device generates the displacement value (530) from the pulse-width-modulated intermediate signal (533) using a low pass (205).

11. A method for determining the current position of a rotor, in particular the angle of rotation of the rotor, of an electric motor (M),
- wherein the current position of the rotor **is determined** based on the variations (SA) of the armature current or the armature voltage **of the electric motor caused by the commutation of the electric motor,**
**characterized in that**
- **the variations (SA) of the armature current or the armature voltage are separated** from the variations (SM) of the motor current or the motor voltage by means of an amplifier unit (100) in accordance with a controllable displacement value (530),
- wherein said displacement value (530) is changed in accordance with the motor current or the motor voltage or the variations (SM) of the motor current or the motor voltage.

## Revendications

1. Dispositif pour déterminer la position actuelle d'un rotor, en particulier l'angle de rotation du rotor, d'un moteur électrique (M),
- ce dispositif déterminant la position actuelle du rotor à l'aide des variations (SA) du courant d'induit ou respectivement de la tension d'induit du moteur électrique (M) qui **sont causées par la commutation du moteur électrique,**
**caractérisé en ce que**
- ce dispositif opère une séparation entre les variations (SA) du courant d'induit ou respectivement de la tension d'induit et les variations (SM) du courant de moteur ou respectivement de la tension de moteur à l'aide d'une unité d'amplificateur (100) en fonction d'une valeur de décalage (530) réglable,
- le dispositif modifiant cette valeur de décalage (530) en fonction du courant de moteur ou de la tension de moteur ou respectivement en fonction des variations (SM) du courant de moteur ou de la tension de moteur.

2. Dispositif selon la revendication 1, **caractérisé en ce que** le dispositif modifie la valeur de décalage (530) en fonction d'un signal de commande (520), le dispositif **dérivant** ce signal de commande (520) à partir des valeurs précédentes de courant de moteur ou respectivement de tension de moteur.

3. Dispositif selon la revendication 2, **caractérisé en ce que** le dispositif **dérive** de façon itérative le signal de commande (520) à l'aide de procédés d'évaluation stochastiques à partir des valeurs précédentes de courant de moteur ou respectivement de tension de moteur.

4. Dispositif selon la revendication 3, **caractérisé en ce que** le dispositif **dérive** de façon itérative le signal de commande (520) à l'aide d'un filtre de Kalman à partir des valeurs précédentes de courant de moteur ou respectivement de tension de moteur.

5. Dispositif selon la revendication 2, **caractérisé en ce que** le dispositif dérive le signal de commande (520) à partir d'une ou de plusieurs valeurs de mesure (551) mesurées actuellement des variations (SM) du courant de moteur ou respectivement de la tension de moteur.

6. Dispositif selon la revendication 2, **caractérisé en ce que** le dispositif dérive le signal de commande (520) à partir de valeurs de mesure (552) des variations (SM) du courant de moteur ou respectivement de la tension de moteur qui ont été mesurées et enregistrées tout de suite après l'assemblage du dispositif avec le moteur électrique (M) pour différents régimes du moteur électrique (M).

7. Dispositif selon la revendication 6, **caractérisé en ce que**, parmi les régimes du moteur électrique (M), il y a les régimes suivants :
- le moteur électrique (M) démarre,
- le moteur électrique (M) accélère,
- le moteur électrique (M) freine,
- le moteur électrique (M) atteint la butée de fin de course mécanique.

8. Dispositif selon une des revendications 2 à 7, **caractérisé en ce que** ce dispositif dérive une pluralité de signaux numériques (531) à partir du signal de commande (520) et produit la valeur de décalage (530) à partir de cette pluralité de signaux numériques (531) à l'aide d'un réseau R/2R (202).

9. Dispositif selon une des revendications 2 à 7, **caractérisé en ce que** ce dispositif produit un signal intermédiaire (533) à modulation de largeur d'impulsions à partir du signal de commande (520) à l'aide de la modulation de largeur d'impulsions et produit la valeur de décalage (530) à partir du signal intermédiaire (533).

10. Dispositif selon la revendication 9, **caractérisé en ce que** ce dispositif produit la valeur de décalage (530) à partir du signal intermédiaire (533) à modulation de largeur d'impulsions à l'aide d'un filtre passe-bas (205).

11. Procédé de détermination de la position actuelle d'un rotor, en particulier de l'angle de rotation du rotor, d'un moteur électrique (M),
- la position actuelle du rotor étant déterminée à l'aide des variations (SA) du courant d'induit ou respectivement de la tension d'induit du moteur électrique **causées par la commutation du moteur électrique,**
**caractérisé en ce que**
- **les variations (SA) du courant d'induit ou respectivement de la tension d'induit sont** séparée des variations (SM) du courant de moteur ou de la tension de moteur par une unité d'amplificateur (100) en fonction d'une valeur de décalage (530) réglable,
- cette valeur de décalage (530) étant modifiée en fonction du courant de moteur ou de la tension de moteur ou respectivement en fonction des variations (SM) du courant de moteur ou de la tension de moteur.
